# EUROPEAN PATENT APPLICATION

(11) **EP 4 661 075 A1**
(43) Date of publication of application: **10.12.2025**
(21) Application number: 24180492.1
(22) Date of filing: 06.06.2024
(51) Int. Cl.: H01L 23/04, H01L 23/055, H01L 23/10

(54) **MICROELECTRONIC PACKAGE AND ELECTRONIC DEVICE COMPRISING SUCH MICROELECTRONIC PACKAGE**

(71) Applicant: Cercuits, 2440 Geel (BE)
(72) Inventor: LUPPENS, Frederik, 2440 Geel (BE); MANGELSCHOTS, Ruben, 2440 Geel (BE); JANSSENS, Giel, 2440 Geel (BE); CHRISTIAENSEN, Tim, 2440 Geel (BE); PEETERS, Thomas, 2440 Geel (BE)
(74) Representative: Sarlet, Stephanie

(57) **Abstract**

A microelectronic package comprising a stack of modular elements which together form an enclosure with a cavity inside for holding a microelectronic device, wherein the stack of modular elements comprises, for at least two modular elements of the stack, a connection system that joins the respective modular elements to each other, wherein the connection system is formed by mating portions of the respective modular elements, which extend around the cavity and mate with each other, and an adhesive applied along the mating portions.

## Description

### Field of the disclosure

The present disclosure relates to a microelectronic package forming an enclosure with a cavity inside for holding a microelectronic device (component or die). The present disclosure further relates to an electronic device comprising one or more such microelectronic packages.

### Background art

Known microelectronic package structures may comprise several layers which are to be precisely stacked and attached on top of each other. As a result, the known structures can only be manufactured with specific tooling, the design process may require a lot of time and the manufacturing of the packages is only cost efficient in case of large volumes. This is particularly the case for hermetic and/or ceramic packages.

A microelectronic package is for example known from US 5448826 A. This document discloses a ceramic microelectronic package suitable for high-frequency microelectronic devices. The package includes a base which is at least partially conductive attached either by seal glass or by solder to a ceramic RF substrate with a cavity formed at its center and a pattern of conductive paths for providing interconnection from the inside to the outside of the package. The base may be metal or ceramic with a metal layer deposited thereon. A ceramic seal ring with a second cavity corresponding to that of the RF substrate, but slightly larger, is attached to the RF substrate by seal glass which is patterned to generally match the dimensions of the seal ring. A ceramic lid is attached to the top of the seal ring by a nonconductive adhesive, such as a polymer adhesive or low temperature seal glass, to seal the package once the microelectronic device has been mounted inside.

### Summary of the disclosure

An aim of the present disclosure may be to provide a microelectronic package with a modular structure.

Another aim of the present disclosure may be to provide a microelectronic package with which the time period between design and manufacturing may be considerably reduced.

Yet another aim of the present disclosure may be to provide a microelectronic package that may be cost efficiently produced in smaller volumes.

In an aspect, which may be combined with other aspects and/or embodiments described herein, the present disclosure relates to a microelectronic package comprising a stack of modular elements which together form an enclosure with a cavity inside for holding a microelectronic device, wherein the stack of modular elements comprises, for at least two modular elements of the stack, a connection system that joins the respective modular elements to each other, wherein the connection system is formed by mating portions of the respective modular elements, which extend around the cavity and mate with each other, and an adhesive applied along the mating portions. The mating portions preferably extend all around the cavity and the adhesive is preferably applied all along the mating portions.

By use of this connection system, the modular elements that are provided with the connection system may mechanically fitted onto each other by means of the mating portions. These mating portions may facilitate alignment of the modular elements with each other and may prevent or minimize lateral movements of the modular elements with respect to each other during manufacturing or afterwards. The applied adhesive may ensure the joining of the modular elements to each other and may prevent delamination of the modules from each other.

By use of the modular structure, the design process of a package suitable for the intended purpose may be considerably reduced. For any new package for a specific microelectronic device, use can be made of a number of predesigned modular elements depending on parameters like the area and/or height of the device, number of contact pads needed, etc.

Furthermore, by use of the modular structure in combination with the connection system, that may be present on each two modular elements that are joined together, the production of the packages in smaller volumes becomes cost efficient. The use of specific tooling, for example to ensure precise alignment of the elements that are stacked on top of each other, may be avoided.

In embodiments according to the present disclosure, the mating portions may comprise at least one peripheral groove in a top side of a first of the modular elements and at least one corresponding ridge on an opposing side of a second of the modular elements, and wherein the adhesive is applied in the at least one groove. The at least one peripheral groove and corresponding ridge preferably extend all around the cavity and the adhesive is preferably applied all along the at least one groove.

In embodiments, the connection system may be present between each two adjacent modular elements of the stack, i.e. each two modular elements that are stacked on top of each other may be joined together by the connection system.

In embodiments, the adhesive may be a sealing adhesive, such as for example an epoxy, acrylic, ceramic or glass adhesive, such that the connection system forms a seal around the cavity. Thus, the combination of the mechanical and adhesive elements in the connection system may seal the package and provide hermiticity. In this way, the connection system may contribute to a hermetic package wherein the cavity, and a microelectronic device that is held therein, is sealed from the environment by the enclosure.

In embodiments, the microelectronic package may be a hermetic package, wherein the cavity, and a microelectronic device that is held therein, is sealed from the environment. The microelectronic package according to embodiments of the present disclosure may thus be used in electronic devices suitable for use in harsh environments and/or space, wherein one or more microchips is/are stored in a sealed cavity by means of a hermetic package having a modular structure as disclosed herein.

In embodiments, the microelectronic package, or part thereof, may be a ceramic package. One or more of the modular elements may be manufactured in a ceramic material, such as for example alumina, aluminum nitride, silicon nitride, silicon carbide, or other.

In an aspect, which may be combined with other aspects and/or embodiments described herein, the present disclosure relates to a microelectronic package comprising a stack of modular elements as described herein, wherein the stack may comprise at least one lower element forming a bottom layer of the enclosure, at least one intermediate element forming an intermediate layer of the enclosure, and an upper element forming a cover of the enclosure. The bottom layer of the enclosure may be made up of one, two, three or more lower elements that together form a bottom part of the enclosure and define its footprint. The intermediate layer may comprise one or more intermediate elements, stacked on top of the bottom layer and used to add height to the package. The upper layer may be optional and may comprise a cover, stacked on top of the intermediate layer and provided for closing off or sealing off a top side of the enclosure.

In embodiments, the bottom layer may comprise at least two lower elements that fit into and over each other, wherein the connection system is provided on a top side of a peripheral portion of the respective inner lower element and on a bottom side of an overhanging portion of the respective outer lower element. One or more of the lower elements may comprise an array of contact structures to provide conductive paths between the inside or the cavity and the bottom side of the package, i.e. to connect contact pads of a microelectronic device held in the cavity of the enclosure with external contact pads.

In an aspect, which may be combined with other aspects and/or embodiments described herein, the intermediate element and the upper element, may be joined to each other by a further connection system that is formed by a peripheral groove in a top side of the intermediate element, a planar, opposing portion of a bottom side of the upper element and an adhesive applied in the peripheral groove and between the top side of the intermediate element and the opposing portion of the upper element. This further connection system is somewhat different from the connection system described above in the sense that the opposing portion of the upper element is planar and may not have the at least one ridge that mates with the at least one groove. In this further connection system, the groove or grooves function to accommodate excess adhesive that is applied for joining the upper element to the intermediate element and is particularly suitable in case the upper element is a glass cover, although not limited thereto. More in general, this further connection system may also be applied to join together any two adjacent modular elements of a microelectronic package, i.e. any respective pair of modular elements that are stacked on top of each other.

In an aspect, which may be combined with other aspects and/or embodiments described herein, the present disclosure relates to a method for manufacturing a microelectronic package as disclosed herein, comprising the steps of providing at least one peripheral groove in a top side of a first modular element of the package, applying an adhesive in the at least one peripheral groove and subsequently stacking a second modular element of the package on top of the first modular element, wherein the adhesive is applied in such an amount that the second modular element is joined to the first modular element.

In embodiments, the second modular element may comprise at least one ridge corresponding to the at least one peripheral groove, wherein ridge(s) enter(s) into the respective groove(s) upon stacking the second modular element on top of the first modular element and pushes some of the adhesive upwards and potentially out of the groove(s). In other words, the ridge(s) may cause the adhesive to rise in the groove(s) and potentially spill over the top of the groove(s).

In embodiments, the second modular element may comprise on its bottom side a planar, opposing portion that is placed on top of the top side of the first modular element, wherein the adhesive is applied in an excess amount to completely fill the at least one groove and extend at least partly between the top side of the first modular element and the opposing planar portion of the bottom side of the second modular element.

In an aspect, which may be combined with other aspects and/or embodiments described herein, the present disclosure relates to an electronic device comprising a circuit board and at least one microelectronic package as disclosed herein provided on the circuit board.

In embodiments, the microelectronic package may comprise a bottom layer or bottom part that is an integral part of the circuit board.

In embodiments, the circuit board itself may form the bottom layer of a further microelectronic package, which may also be a microelectronic package as disclosed herein.

### Brief description of the drawings

Embodiments of the present disclosure will be discussed in more detail below, with reference to the attached drawings.
Fig. 1 shows a top perspective view of an embodiment of a microelectronic package according to the present disclosure.
Fig. 2 shows a bottom perspective view of the microelectronic package of Fig. 1.
Fig. 3 shows a cross-sectional view of the microelectronic package of Fig. 1.
Fig. 4 shows a top perspective exploded view of the microelectronic package of Fig. 1.
Fig. 5 shows a bottom perspective exploded view of the microelectronic package of Fig. 1.
Figs. 6 and 7 show top perspective views of another embodiment of a microelectronic package according to the present disclosure.
Fig. 8 shows a cross-sectional view of the microelectronic package of Figs. 6 and 7.
Fig. 9 shows a top perspective view of an embodiment of a microelectronic device according to the present disclosure.
Fig. 10 shows a bottom perspective view of the microelectronic device of Fig. 9.
Fig. 11 shows a top view of the microelectronic device of Fig. 9.
Fig. 12 shows a cross-sectional view of the microelectronic device of Fig. 9.
Fig. 13 shows a top perspective exploded view of the microelectronic device of Fig. 9.
Fig. 14 shows a bottom perspective exploded view of the microelectronic device of Fig. 9.

### Description of embodiments

Below, particular embodiments according to the disclosure are described with reference to certain drawings but the disclosure is not limited thereto. The drawings described are only schematic and are non-limiting. In the drawings, the size of some of the elements may be exaggerated and not drawn on scale for illustrative purposes. The dimensions and the relative dimensions do not necessarily correspond to actual reductions to practice of the disclosure.

The terms first, second, third and the like in the description and in the claims, are used for distinguishing between similar elements and not necessarily for describing a sequential or chronological order. The terms are interchangeable under appropriate circumstances and the embodiments of the disclosure can operate in other sequences than described or illustrated herein.

The terms top, bottom, over, under and the like in the description and the claims are used for descriptive purposes and not necessarily for describing relative positions. The terms so used are interchangeable under appropriate circumstances and the embodiments of the disclosure described herein can operate in other orientations than described or illustrated herein.

As (micro) electronics become more powerful, widely used, miniaturized, and integrated, the favorable properties of ceramic materials may support more performant and reliable applications by using these materials for (hermetic) packages. Conventional technologies to make such packages like Low Temperature Co-Fired Ceramic (LTCC) and High Temperature Co-Fired Ceramic HTCC may be slow, expensive, and difficult, and do not suit low-volume, research, or development programs.

The present disclosure provides modular (ceramic) microelectronics packages that are easy to customize. The packages may comprise modular elements in a lower layer, an intermediate layer and an upper layer. The lower layer may comprise one or more lower modular elements with a single or double sided circuit layer onto. The intermediate layer may comprise one or more ring or intermediate modular elements. The top layer is optional and may comprise an upper modular element (lid or cover). All the modular layers and/or modular elements may fit mechanically into or onto each other by grooves and corresponding, opposing ridges that are made within the material of the respective layer or element. These grooves and ridges may function to align and lock the layers or elements in lateral directions. With the addition of an adhesive along these mating portions of the modular layers or elements, delamination in height direction may further be prevented. The mating portions (grooves and ridges) and adhesive combined are herein referred to as the connection system. Any two adjacent modular elements of the stack may be joined together by this connection system.

The lower modular elements may have a single or double-sided circuit, may have a ceramic core (for example in alumina, aluminum nitride, silicon nitride, silicon carbide, or other ceramic material) and may have conductive structures such as tracks, bond pads and solder pads that can be wire bonded, glued, welded, brazed or soldered to, in order to make a connection with a component, connector or a printed circuit board. The conductive tracks may be made with any conductive material, for example copper, tin, titanium, titanium-nitride, silver, silver-palladium, silver-platinum gold, or other, and optionally finished with one or more layers of materials like nickel, palladium, silver, gold, tin and/or other surface finishes. The conductive structures or paths may be made on the top, bottom and edges/sides of these lower modular elements. The lower layer may have one or more cavities in which the components or dies can be placed.

The connection system may comprise one or more ridges that fit into an opposing groove and a sealing adhesive such as epoxy, acrylic, ceramic or glass adhesive may be used to bond the modular layers or elements together. The combination of the mechanical and adhesive elements in the connection system may seal the package and provide hermiticity.

The ring(s) or intermediate modular elements may be used to increase the space inside the package by increasing its height below the lid. The intermediate elements may also be made from a ceramic material. The intermediate elements may typically have no metallization, but an intermediate element may also have conductive structures or traces, for example to bring a conductive track to the top of the package or to provide a metallic ring onto which the lid may be soldered or welded.

The upper modular element (lid or cover) may for example be in a metallic, ceramic or glass material that seals the package from the top. At least on this upper element, the ridges are optional and if not present, the grooves on the layer below may serve the purpose of taking up excess adhesive.

In embodiments, the dimensions of the mating portions, in particular the peripheral grooves and ridges, may vary widely. For example, the mating portions, in particular the peripheral grooves and ridges, may have dimensions (width and/or height in cross section) in the range of 50 to 1000 µm, preferably 100 to 200 µm.

In embodiments, the dimensions of the packages and/or devices may vary widely. The enclosed cavities may for example have a diameter (width or length) of at least 0.5 mm, 1.0 mm or 1.5 mm up to a few cm or more. The height of the cavities may for example be at least 0.2 mm, 0.3 mm, 0.4 mm or 0.5 mm up to 1.0 mm or more.

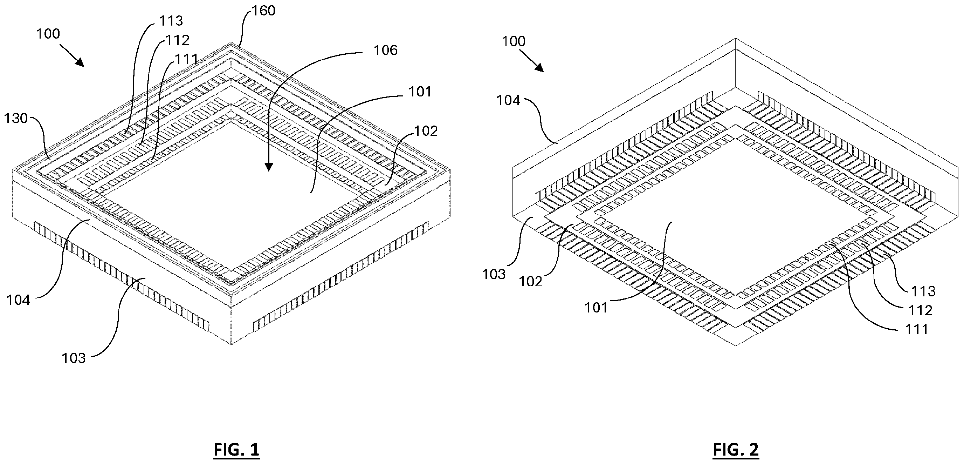

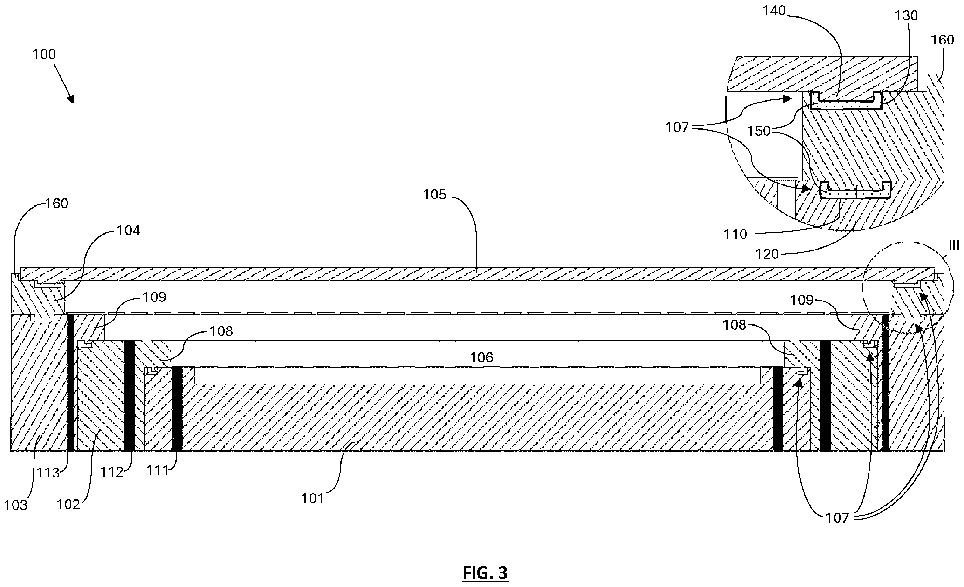

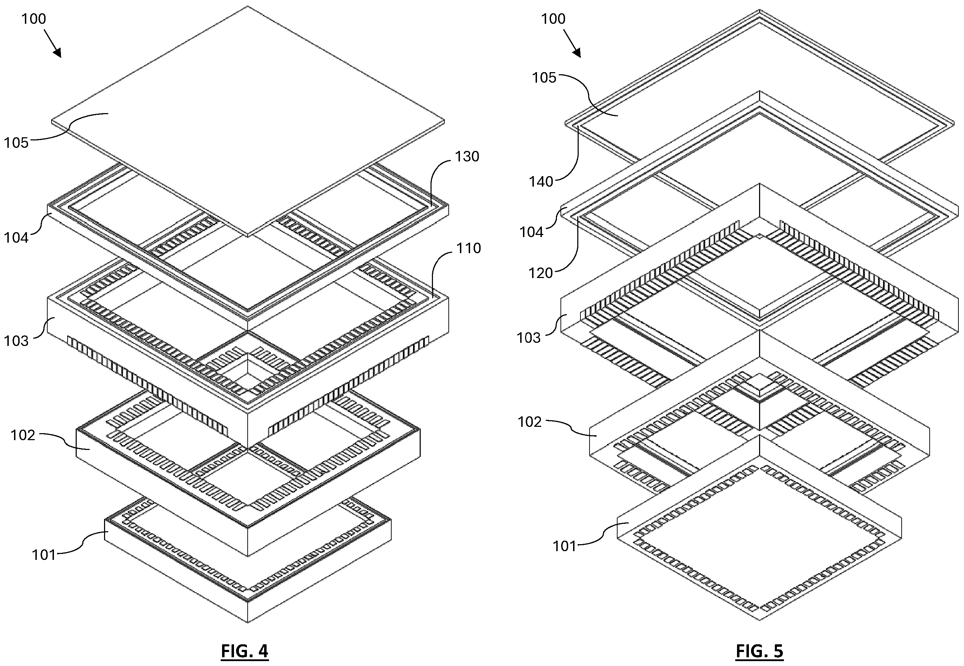

A first embodiment will be described with reference to Figs. 1-5, of which Fig. 1 shows a top perspective view of the microelectronic package 100 (with the lid removed), Fig. 2 shows a bottom perspective view, Fig. 3 shows a cross-sectional view and Figs. 4 and 5 show exploded views.

The microelectronic package 100 comprises a stack of modular elements 101, 102, 103, 104, 105 which together form an enclosure with a cavity 106 inside for holding a microelectronic device. The stack of modular elements comprises first 101, second 102 and third 103 lower elements that fit into and on top of each other and together form a lower part or lower layer of the enclosure, an intermediate part 104 and a lid 105. The modular elements 101-105 are joined to each other by means of the connection system 107 that comprises mating portions 110-120, 130-140 of the respective modular elements in combination with an adhesive 150. The mating portions may comprise, respectively, a groove 110, 130 and a ridge 120, 140 located in a peripheral part of the respective modular element. The grooves and ridges extend all around the cavity and mate with each other to form a tongue-in-groove connection. The adhesive 150 is preferably applied all along the mating portions, i.e. preferably also all around the cavity.

In the embodiment shown in Figs. 1-5, the connection system 107 is present between each two adjacent modular elements of the stack, i.e. each two modular elements that are stacked on top of each other are joined together by the connection system 107. As shown, the dimensions of the mating portions, i.e. the grooves and ridges, may vary.

The microelectronic package 100, or part thereof, may be a ceramic package. One or more of the modular elements 101-105 may be manufactured in a ceramic material, such as for example alumina, aluminum nitride, silicon nitride, silicon carbide, or other. The adhesive 150 may be a sealing adhesive, such as for example an epoxy, acrylic, ceramic or glass adhesive, such that the connection system 107 forms each time a seal around the cavity 106. In this way, a hermetically sealed package may be obtained for holding a microelectronic device sealed from the environment. This microelectronic package 100 may thus be used in harsh environments and/or space.

The lower elements 101, 102, 103 that form a bottom layer of the enclosure fit into and over each other. Here, the connection system 107 is provided on a top side of a peripheral portion of the respective inner lower element 101, 102 and on a bottom side of an overhanging portion 108, 109 of the respective outer lower element 102, 103. In particular, the connection between the first 101 and second 102 modular elements is made between a peripheral portion of the first element 101 and an overhanging portion 108 of the second element, and the connection between the second 102 and third 103 modular elements is made between a peripheral portion of the second element 102 and an overhanging portion 109 of the third element. Each of these lower elements 101, 102, 103 comprises an array of contact structures 111, 112, 113, in particular inside and outside contact pads interconnected by vertical structures such as vias, to provide conductive paths between the inside of the cavity and the bottom side of the package. These can be used to connect contact pads of a microelectronic device held or stored in the cavity of the enclosure with external contact pads of the package. In the embodiment shown, there are three lower elements, each with an array of contact structures, but there may also be fewer or more lower elements depending on the desired cavity area, the number of contact structures needed, etc.

The intermediate element 104 is a ring element which is stacked on top of the bottom layer, in particular the outer or third lower element 103. In Fig. 3, the enlarged view of the circle III shows the groove 110 in the element 103 and the ridge 120 on the bottom side of the intermediate element 104 and the adhesive 150 in between. This intermediate element 104 is used to add height to the package, i.e. to increase the cavity in height direction. The intermediate element shown here does not have metallization. In alternative embodiments, an intermediate element may also have conductive structures or traces, for example to bring a conductive track to the top of the package or to provide a metallic ring onto which the lid may be soldered or welded. In the embodiment shown, there is one intermediate element, but in alternative embodiments there may also be two or more intermediate elements depending on for example the desired height of the cavity and/or if for example one intermediate with metallization and one without metallization is desired.

The lid or cover 105 forms an upper layer of the package, stacked on top of the intermediate layer 104 and provided for closing off or sealing off a top side of the enclosure. In Fig. 3, the enlarged view of the circle III shows the groove 130 in the element 104 and the ridge 140 on the bottom side of the lid 105 and the adhesive 150 in between. The lid 105 may for example be in a metallic, ceramic or glass material that seals the package from the top.

In the embodiment shown, the lid 105 comprises the ridge 140 on the bottom side for forming the connection with the intermediate element 104. This ridge 140 is optional. In alternative embodiments, the intermediate element 104 and the lid 105 may be joined to each other by a different connection system where this ridge is absent, i.e. a connection system that is formed by the peripheral groove 130 in the top side of the intermediate element 104, a planar, opposing portion of the bottom side of the lid 105 and an adhesive 150 applied in the peripheral groove 130 and between the top side of the intermediate element and the opposing portion of the upper element. So in such embodiments, the bottom side of the lid may be fully planar and the groove 130 may function to accommodate excess adhesive that is applied for joining the lid 105 to the intermediate element 104.

For stacking the modular elements 101-105 on top of each other and joining them to each other, the adhesive is applied in such an amount in the respective grooves that the respective upper modular element is joined to the respective lower modular element, taking into account that the respective ridge enters into the respective groove and may push some of the adhesive upwards and potentially out of the groove. In case the ridge on the lid 105 is absent, i.e. the lid has a fully planar bottom side, the adhesive is applied in an excess amount to completely fill the groove 130 in the intermediate element 104 and to extend at least partly between the top side of the intermediate element 104 and the planar bottom side of the lid 105.

In order to facilitate positioning of the lid 105 on top of the intermediate element 104, the latter may have a top rim 160 around its periphery. Once stacked, this top rim 160 surrounds the periphery of the lid 105.

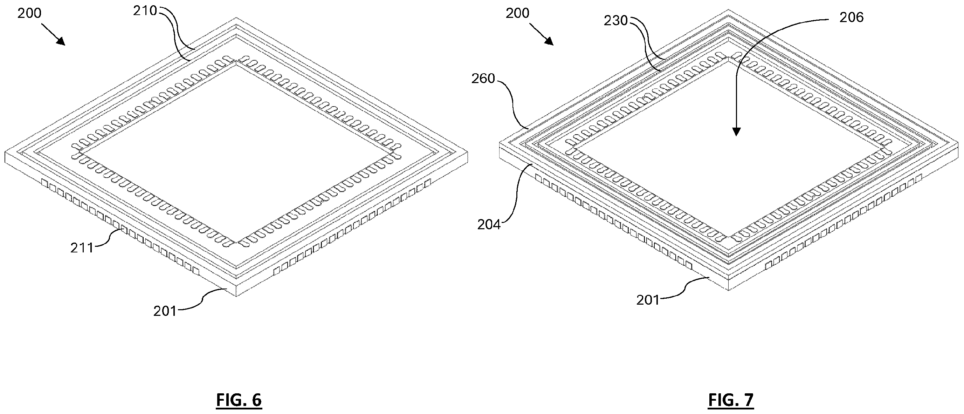

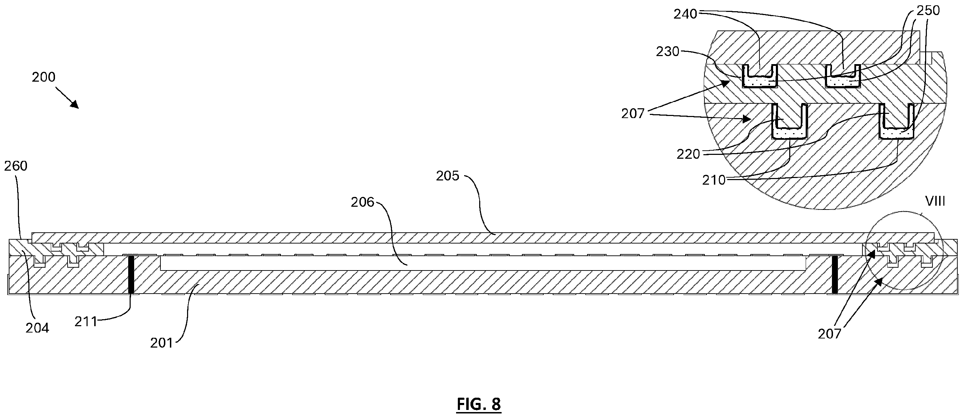

A second embodiment will be described with reference to Figs. 6-8, of which Fig. 6 shows a top perspective view of the bottom layer of the microelectronic package 200, Fig. 7 shows a top perspective view of the bottom layer with the intermediate layer stacked on top and Fig. 8 shows a cross-sectional view.

The microelectronic package 200 comprises a stack of modular elements 201, 204, 205 which together form an enclosure with a cavity 206 inside. The stack comprises a single lower element 201, a single intermediate element 204 and a lid 205. The modular elements 201, 204, 205 are joined to each other by means of a connection system 207 that comprises mating portions with dual grooves 210, 230 and ridges 220, 240 in combination with an adhesive 250, located in peripheral parts of the respective modular elements. The grooves and ridges extend all around the cavity and mate with each other to form tongue-in-groove connections. The adhesive 250 is preferably applied all along the mating portions, i.e. preferably also all around the cavity. As shown, the dimensions of the mating portions, i.e. the grooves and ridges, may vary.

The microelectronic package 200, or part thereof, may likewise be a ceramic package. One or more of the modular elements 201, 204, 205 may be manufactured in a ceramic material. The adhesive 250 may be a sealing adhesive, such that the connection system 207 forms each time a seal around the cavity 206 and a hermetically sealed package may be obtained.

The lower elements 201 forms a bottom layer of the enclosure and comprises an array of contact structures 211, in particular inside and outside contact pads interconnected by vertical structures such as vias, to provide conductive paths between the inside of the cavity and the bottom side of the package. These can be used to connect contact pads of a microelectronic device held or stored in the cavity of the enclosure with external contact pads of the package.

The intermediate element 204 is a ring element which is stacked on top of the bottom layer, in particular the lower element 201. In Fig. 8, the enlarged view of the circle VIII shows the grooves 210 in the element 201 and the ridges 220 on the bottom side of the intermediate element 204 with the adhesive 250 in between. This intermediate element 204 is used to add height to the package, i.e. to increase the cavity in height direction. The intermediate element shown here does not have metallization.

The lid or cover 205 forms an upper layer of the package, stacked on top of the intermediate layer 204 and provided for closing off or sealing off a top side of the enclosure. In Fig. 8, the enlarged view of the circle VIII shows the grooves 230 in the element 204 and the ridges 240 on the bottom side of the lid 205 with the adhesive 250 in between. The lid 105 may for example be in a metallic, ceramic or glass material that seals the package from the top.

In the embodiment shown, the lid 205 comprises the ridges 240 on the bottom side for forming the connection with the intermediate element 204. In the same way as described for the first embodiment, these ridges 240 are optional and the bottom side of the lid may be planar. In such embodiments, the grooves 230 may function to accommodate excess adhesive that is applied for joining the lid 205 to the intermediate element 204.

In order to facilitate positioning of the lid 205 on top of the intermediate element 204, the latter may have a top rim 260 around its periphery. Once stacked, this top rim 260 surrounds the periphery of the lid 205.

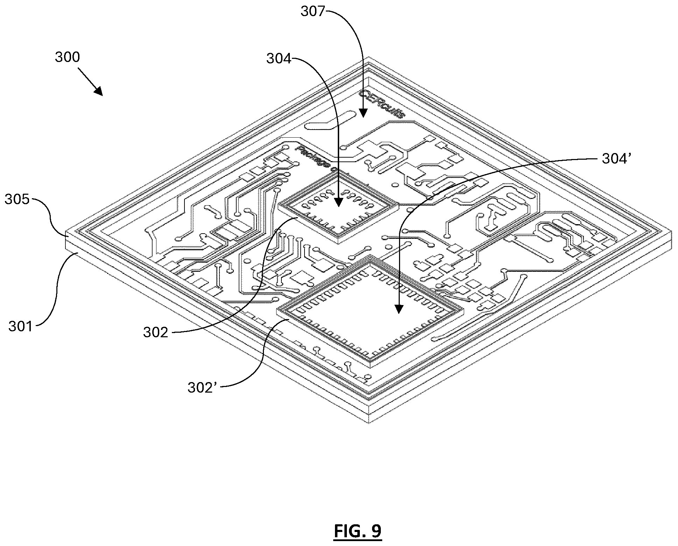

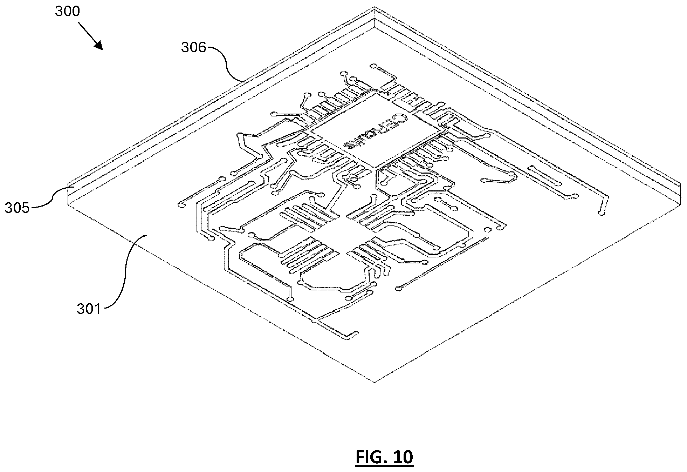

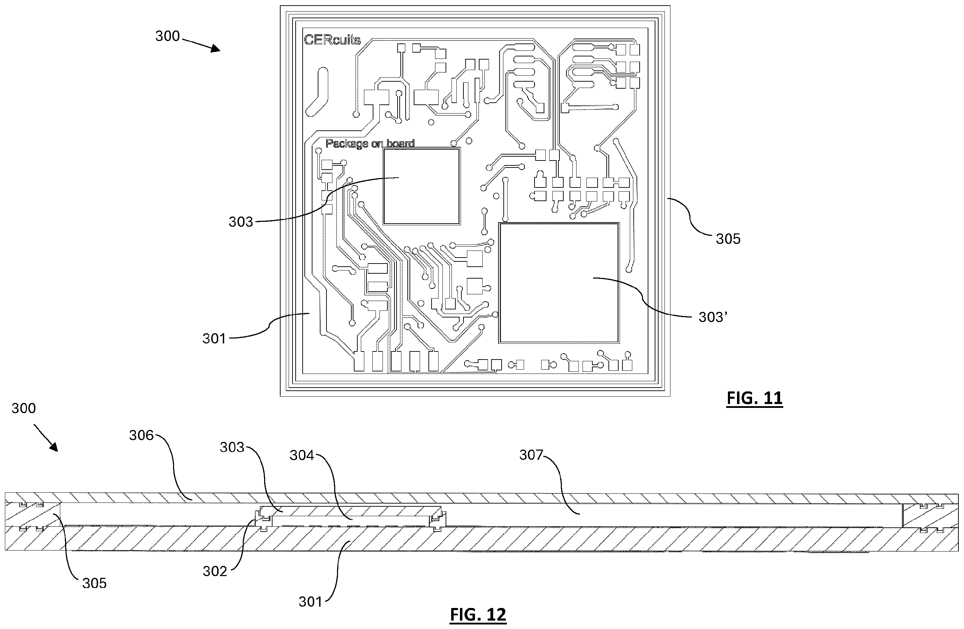

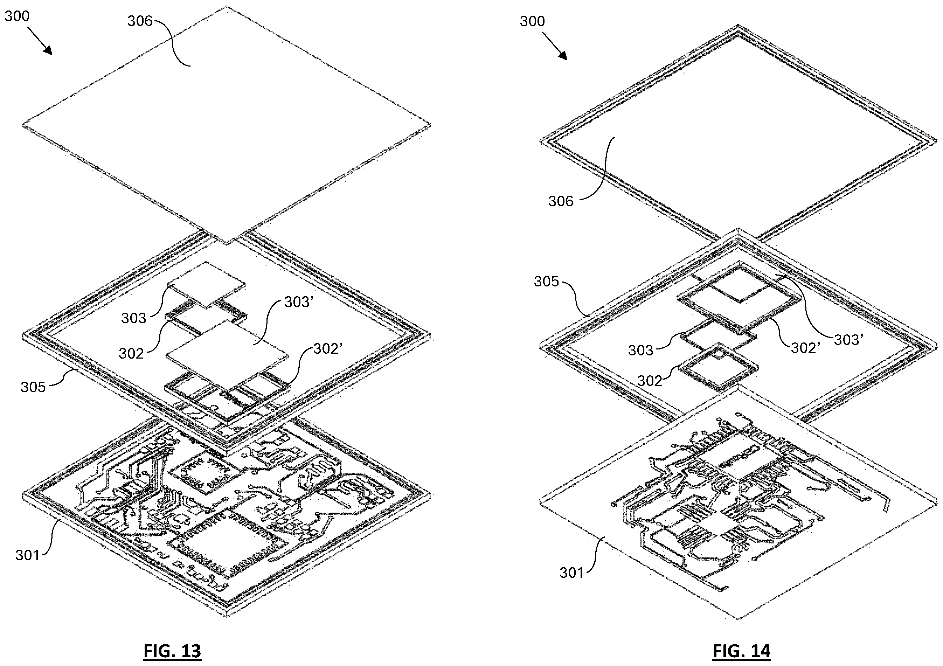

With reference to Figs. 9-14, an embodiment of an electronic device or structure according to the present disclosure will now be described, which may be used in multichip package devices or package-on-board devices or the like. The device 300 comprises a circuit board on which modular enclosure structures as described above are integrated and which in itself form the bottom layer of a further, larger enclosure. Fig. 9 shows a top perspective view of the microelectronic device 300 (with the lids of the enclosures removed); Fig. 10 shows a bottom perspective view; Fig. 11 shows a top view (with the lid of the larger enclosure removed); Fig. 12 shows a cross-sectional view; and Figs. 13 and 14 respectively show a top perspective exploded view and a bottom perspective exploded view.

As shown by means of the electronic device 300, at least one microelectronic package as disclosed herein may be provided on and/or integrated with a circuit board 301. In particular, on the circuit board 301 shown in the figures, the bottom layer of two microelectronic packages is integrated to form enclosures for cavities 304, 304' in which further microelectronic devices (e.g. components or dies) may be included. These two microelectronic packages have a structure similar to that of Figs. 6-8, in particular comprising a single element (a portion of the circuit board 301) as bottom layer, a single intermediate element or ring 302, 302' and a lid 303, 303'. The elements 301, 302, 303, respectively 301, 302', 303' are joined to each other by means of a connection system as disclosed herein, in particular each time a peripheral groove with a mating peripheral ridge and adhesive along the groove and ridge.

Further, as shown by means of the electronic device 300, the circuit board 301 itself (as a whole) may also form the bottom layer of a modular package to form an enclosure for a larger cavity 307 between the circuit board and a further lid 306. This modular package likewise has a structure similar to that of Figs. 6-8, in particular comprising a single element (the circuit board 301) as bottom layer, a single intermediate element or ring 305 and the lid 306. The elements 301, 305, 306 are joined to each other by means of a connection system as disclosed herein, in particular each time a dual peripheral groove with a mating dual peripheral ridge and adhesive along the grooves and ridges.

In variant embodiments of electronic devices within the scope of the present disclosure, the circuit board may comprise one, two, three or more smaller modular package structures like the packages 301-302-303, 301-302'-303'. These smaller package structures may have one or more intermediate or ring elements 302, 302' and the joint may be formed by any embodiment of a connection system as disclosed herein, for example two or more peripheral grooves and ridges and/or one or more peripheral groove(s) in combination with a planar opposing part where the groove(s) functions to take up excess adhesive. Further, the lid 303, 303' may be an optional element. In order to facilitate positioning of the lid 303, 303' on top of the respective intermediate element 302, 302', the latter may have a top rim around its periphery, as shown.

In variant embodiments of electronic devices within the scope of the present disclosure, the circuit board may form part of any larger modular package structure comprising a connection system as disclosed herein. The larger package structure 301-305-306 may have one or more intermediate or ring elements 305 and the joint may be formed by any embodiment of a connection system as disclosed herein, for example a single peripheral groove and ridge or more than two peripheral grooves and ridges, and/or one or more peripheral groove(s) in combination with a planar opposing part where the groove(s) functions to take up excess adhesive.

As shown, the grooves and ridges of the modular elements 301-303, 305, 306 preferably extend all around the respective cavities 304, 304', 307 and mate with each other to form tongue-in-groove connections. The adhesive is preferably applied all along the mating portions, i.e. preferably also all around the cavity.

The device 300, or part thereof, may likewise be in a ceramic material. In particular, the circuit board 301 may be a ceramic substrate and one or more of the modular elements 302, 303, 305, 306 may be manufactured in a ceramic material. The adhesive may be a sealing adhesive, such that the respective connection system forms each time a seal around the respective and one or more of the package structures may form a hermetically sealed package structure. In other words, the smaller cavities 304, 304' may be hermetically sealed from the larger cavity 307 and the larger cavity itself may be hermetically sealed from the environment. As shown, the circuit board 301 may comprise arrays of contact structures to form conductive connections between the inside of the cavities 304, 304', 307 and the bottom side of the device 300.

The intermediate elements 302, 302', 305 shown do not have metallization. In embodiments, the intermediate elements of the respective packages may also have conductive structures or traces, for example to bring a conductive track to the top of the respective package or to provide a metallic ring onto which the respective lid may be soldered or welded. The lids 303, 303', 306 may for example be in a metallic, ceramic or glass material that seals the respective package from the top.

Embodiments of microelectronic packages and/or devices according to the present disclosure may have several advantages over traditional manufacturing methods:
- use of specific tooling may be avoided, which may reduce the cost and time required to manufacture new products;
- more design freedom: the disclosed modular structure for packages allow for more design freedom compared to traditional manufacturing methods;
- smaller features: the disclosed modular structure for packages may be used to create smaller structural features and electronic circuit lines and pads compared to traditional manufacturing methods;
- higher precision;
- use of copper as base conductor: pure copper may be used as the base conductor which may be finished with finishes like immersion tin, immersion silver, gold, ENIG or ENEPIG. This is advantageous compared to the use of conductive pastes or expensive metals in LTCC and HTCC.

Embodiments of microelectronic packages and/or devices according to the present disclosure may be used in the following applications:
- RF packages, potentially with 3D features such as cavities and waveguides;
- power electronics, potentially with integrated heat sinks and/or cooling channels;
- optoelectronics, potentially with 3D features such as lens holders and mirrors;
- MEMS packages, potentially with 3D features, such as sensors and actuators;
- IC submounts and packages, e.g. hermetic and multichip packages.

Some specific examples of possible applications are: a ceramic QFN or leadless carrier for micro electronics, a package for a power amplifier in a mobile device, a hermetically sealed waveguide for a millimeter wave antenna, a power LED module with an integrated heat sink, an optical sensor package for a camera module, a sealed sensor for a self-driving vehicle, a LED-to-fiber package, etc.

## Claims

1. A microelectronic package comprising a stack of modular elements which together form an enclosure with a cavity inside for holding a microelectronic device, wherein the stack of modular elements comprises, for at least two modular elements of the stack, a connection system that joins the respective modular elements to each other, wherein the connection system is formed by mating portions of the respective modular elements, which extend around the cavity and mate with each other, and an adhesive applied along the mating portions.

2. The microelectronic package according to claim 1, wherein the mating portions comprise at least one peripheral groove in a top side of a first of the modular elements and at least one corresponding ridge on an opposing side of a second of the modular elements, and wherein the adhesive is applied in the at least one groove.

3. The microelectronic package according to any of the preceding claims, wherein the connection system is present between each two adjacent modular elements of the stack.

4. The microelectronic package according to any of the preceding claims, wherein the adhesive is a sealing adhesive, such that the connection system forms a seal around the cavity.

5. The microelectronic package according to claim 4, wherein the package is a hermetic package.

6. The microelectronic package according to any of the preceding claims, wherein one or more of the modular elements is made of a ceramic material.

7. The microelectronic package according to any of the preceding claims, wherein the stack of modular elements comprises at least one lower element forming a bottom layer of the enclosure, at least one intermediate element forming an intermediate layer of the enclosure, and an upper element forming a cover of the enclosure.

8. The microelectronic package according to claim 7, wherein the bottom layer comprises at least two lower elements that fit into and over each other and wherein the connection system is provided on a top side of a peripheral portion of the respective inner lower element and on a bottom side of an overhanging portion of the respective outer lower element.

9. The microelectronic package according to claim 7 or 8, wherein each lower element comprises an array of contact structures to provide conductive paths between contact pads of a microelectronic device held in the cavity of the enclosure and external contact pads.

10. The microelectronic package according to any of claims 7-9, wherein the intermediate element extends in height direction above the bottom layer.

11. The microelectronic package according to any of claims 7-10, wherein the intermediate element and the upper element are joined to each other by a further connection system that is formed by a peripheral groove in a top side of the intermediate element, a planar, opposing portion of a bottom side of the upper element and an adhesive applied in the peripheral groove and between the top side of the intermediate element and the opposing portion of the upper element.

12. The microelectronic package according to any of claims 7-11, wherein the intermediate element comprises a top rim that surrounds the periphery of the upper element.

13. An electronic device comprising a circuit board and at least one microelectronic package according to any one of claims 1-12 provided on the circuit board.

14. An electronic device comprising a circuit board and a first microelectronic package according to any one of claims 7-12, wherein the bottom layer of the first microelectronic package is an integral part of the circuit board.

15. The electronic device according to claim 14, wherein the circuit board forms the bottom layer of a second microelectronic package according to any one of claims 7-12.
